# EUROPEAN PATENT SPECIFICATION

(11) **EP 3 620 555 B1**
(45) Date of publication and mention of the grant of the patent: **07.07.2021**
(21) Application number: 17904829.3
(22) Date of filing: 10.07.2017
(51) Int. Cl.: C30B 29/10, C30B 15/00, C30B 17/00, C30B 11/00, C30B 9/12, C30B 7/10, C30B 7/04, C01B 35/12, G02F 1/355

(54) **COMPOUND OF CESIUM FLUOROOXOBORATE, NON-LINEAR OPTICAL CRYSTAL OF CESIUM FLUOROOXOBORATE, PREPARATION METHOD THEREFOR AND USE THEREOF**
CÄSIUMFLUOROOXOBORATVERBINDUNG, NICHTLINEARER OPTISCHER KRISTALL VON CÄSIUMFLUOROOXOBORAT, HERSTELLUNGSVERFAHREN DAFÜR UND VERWENDUNG DAVON
FLUOROOXOBORATE DE CÉSIUM COMPOSÉ, CRISTAL OPTIQUE NON LINÉAIRE DE FLUOROOXOBORATE DE CÉSIUM, PROCÉDÉ DE PRÉPARATION ASSOCIÉ ET UTILISATION ASSOCIÉE

(30) Priority: 03.04.2017 CN 201710215337
(43) Date of publication of application: 11.03.2020
(73) Proprietor: Xinjiang Technical Institute Of Physics&Chemistry, Chinese Academy Of Sciences, Urumqi, Xinjiang 830011 (CN)
(72) Inventor: PAN, Shilie, Urumqi Xinjiang 830011 (CN); WANG, Xuefei, Urumqi Xinjiang 830011 (CN); ZHANG, Fangfang, Urumqi Xinjiang 830011 (CN); WANG, Ying, Urumqi Xinjiang 830011 (CN)
(74) Representative: Hanna Moore + Curley
(86) International application number: PCT/CN2017/092331
(87) International publication number: WO 2018/184312

(56) References cited:
- CN-A- 101 302 647
- CN-A- 101 798 707
- CN-A- 102 071 465
- CN-A- 106 894 085
- US-A1- 2007 125 298
- US-A1- 2017 031 091
- THOMAS PILZ ET AL: "Li2B6O9F2, a New Acentric Fluorooxoborate", ZEITSCHRIFT FUR ANORGANISCHE UND ALLGEMEINE CHEMIE, vol. 637, no. 14-15, 1 December 2011 (2011-12-01), pages 2148-2152, XP055699258, ISSN: 0044-2313, DOI: 10.1002/zaac.201100347
- PAVLIKOV, N. V. et al.: "Sodium fluoride-boron oxide system", Zhurnal Neorganicheskoi Khimii, vol. 19, no. 6, 31 December 1974 (1974-12-31), page 1597, XP009518300, ISSN: 0036-0236

## Description

### TECHNICAL FIELD

The present invention relates to a compound of cesium fluorooxoborate, CsB₄O₆F, a nonlinear optical crystal of CsB₄O₆F, and a method of preparation and use thereof.

### BACKGROUND OF THE INVENTION

As a kind of important components of all-solid-state lasers, nonlinear optical crystals have always been widely concerned both at home and abroad. After half a century's researches, a series of nonlinear optical crystals with excellent properties have been found. Typical nonlinear optical crystals used in the visible light region include KTiOPO₄ (KTP), KH₂PO₄ (KDP), etc. Nonlinear optical crystals used in the ultraviolet region that have been industrialized include LiB₃O₅ (LBO), CsB₃O₅ (CBO), CsLiB₆O₁₀ (CLBO), BaB₂O₄ (BBO), etc. However, KBe₂BO₃F₂ (KBBF) is the only available crystal that can apply in the deep-ultraviolet region below 200 nm. The application of KBBF is restricted due to its long growth period highly toxic element Be and layer growth habit, etc. Therefore, it is necessary to explore new deep-ultraviolet nonlinear optical crystals with better performances.

The inventors developed a compound of ammonium fluorooxoborate, NH₄B₄O₆F, and a nonlinear optical crystal of NH₄B₄O₆F in previous studies, as described in the patent application No. 201611128283.3. The main differences between the present invention and NH₄B₄O₆F is that the NH₄⁺ is linked to the anion group by a hydrogen bond in NH₄B₄O₆F, while the Cs⁺ is linked to the anion group by an ionic bond in CsB₄O₆F, resulting in completely different structures and growth habits, as well as different key parameters of the growth process, crystal properties, and the like between CsB₄O₆F and NH₄B₄O₆F.

Pilz et al, in J. of Solid State Chemistry 186 (2012) 104-108 shows lithium-rich fluorooxoborate.

US 2007 125298 discloses CsBe2BO3F2 crystals for optical applications.

### SUMMARY OF THE INVENTION

An object of the present invention is to provide a compound of cesium fluorooxoborate, which has a chemical formula of CsB₄O₆F and a molecular weight of 291.15 and is prepared by solid-state reaction or vacuum encapsulation method.

Another object of the present invention is to provide a nonlinear optical crystal of cesium fluorooxoborate, which has a chemical formula of CsB₄O₆F and a molecular weight of 291.15. The crystal belongs to an orthorhombic crystal system, with the space group of *Pna*2₁, unit cell parameters of *a* = 7.9241 Å, *b* = 11.3996 Å, *c* = 6.6638 Å, and *α* = *β* = *γ* = 90°, and a unit cell volume of 601.95 Å³.

Yet another object of the present invention is to provide a method for preparing the nonlinear optical crystal of CsB₄O₆F, comprising growing the crystal by a melt method, high temperature solution method, vacuum encapsulation method, hydrothermal method or room temperature solution method.

Yet another object of the present invention is to provide the utilities of the nonlinear optical crystal of CsB₄O₆F.

The present invention provides a compound of cesium fluorooxoborate with the chemical formula of CsB₄O₆F and the molecular weight of 291.15.

In the method for preparing the compound of cesium fluorooxoborate as described herein, the compound is prepared by a solid-state synthesis method or a vacuum encapsulation method.

The solid-state synthesis method for preparing the compound of cesium fluorooxoborate comprises the steps of:
mixing a Cs-containing compound, a B-containing compound and an F-containing compound homogeneously with the molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄.

The vacuum encapsulation method for preparing the compound of cesium fluorooxoborate comprises the steps of:
mixing a Cs-containing compound, a B-containing compound and an F-containing compound homogeneously at a molar ratio of Cs:B:F=0.5-2:3-5:0.5-2; filling the mixture into a Φ40 mm quartz tube; vacuumizing the quartz tube to a vacuum degree of 1×10⁻³ Pa, and sealing it with high temperature; then placing the quartz tube in a muffle furnace, and increasing the temperature to 350-600 °C at a rate of 10-50 °C for 3-96 hours, to give the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄.

Provided herein is a nonlinear optical crystal of cesium fluorooxoborate. The crystal has a chemical formula of CsB₄O₆F with molecular weight of 291.15. The crystal belongs to an orthorhombic crystal system, with the space group of *Pna2₁,* unit cell parameters of *a*=7.9241Å, *b*=11.3996Å, *c*=6.6638Å, and *α*=*β*=γ=90°, and a unit cell volume of 601.95Å³.

In the method of preparing the nonlinear optical crystal of cesium fluorooxoborate as described herein, the crystal is grown by a melt method, high temperature solution method, vacuum encapsulation method, hydrothermal method or room temperature solution method.

The melt method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
b) filling the resultant polycrystal powder of the compound of CsB₄O₆F into a clean platinum crucible; placing the platinum crucible in a muffle furnace, and increasing the temperature to 400-700 °C at a rate of 20-40 °C/h for 7-15 hours, to give a melt; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
c) decreasing the temperature of the melt from step b) to 400-590 °C at a rate of 0.1-5 °C/h, to 300-440 °C at a rate of 0.2-2 °C/h, and further to 30 °C at a rate of 3-15 °C/h, to give a seed crystal of CsB₄O₆F; and
d) growing the crystal in the melt of the compound by the Czochralski method, comprising fixing the seed crystal obtained from step c) onto a seed crystal rod; lowering the seed crystal to 1 mm above the liquid surface from the top of a crystal growing furnace for the melt prepared in step b), and preheating it for 5-60 minutes; then immersing the seed crystal in the liquid at 1-5 mm below the surface; rotating the crystal at 2-30 rpm by a crystal growth controller and controlling the temperature to saturate the melt; lifting the seed crystal at a rate of 1-3 mm/day while keeping the temperature constant; upon completion of the crystal growth, pulling the crystal on the seed crystal rod, and decreasing the temperature to 300-440 °C at a rate of 0.2-2 °C/h, and further to 30 °C at a rate of 3-15 °C/h, to obtain the nonlinear optical crystal of CsB₄O₆F;
alternatively, growing the crystal in the melt of the compound by the Kyropoulos method, comprising
fixing the seed crystal obtained from step c) onto a seed crystal rod; lowering the seed crystal to 1 mm above the liquid surface from the top of a crystal growing furnace for the melt prepared in step b), and preheating it for 5-60 minutes; then immersing the seed crystal in the liquid at 1-5 mm below the surface; decreasing the temperature at a rate of 0.1-0.7 °C/h; 3-10 hours later, lifting the seed crystal by 1-2 mm, and further decreasing the temperature at a rate of 0.1-0.7 °C/h; upon completion of the crystal growth, pulling the crystal on the seed crystal rod, and decreasing the temperature to 300-440 °C at a rate of 0.2-2 °C/h, and further to 30 °C at a rate of 3-15 °C/h, to obtain the nonlinear optical crystal of CsB₄O₆F;
alternatively, growing the crystal in the melt of the compound by the Bridgeman-Stockbarger method, comprising
placing the seed crystal prepared in step c) at the bottom of a crucible, then adding the polycrystal compound of CsB₄O₆F prepared in step a) to the crucible; sealing the platinum crucible, and increasing the temperature of the growing furnace to 500-700 °C for 7-15 hours; adjusting the position of the crucible such that the seeding temperature is 500-625 °C; then lowering the crucible at a rate of 1-10 mm/day while keeping the growth temperature constant; upon completion of the growth, decreasing the temperature to 300-440 °C at a rate of 0.2-2 °C/h, and further to 30 °C at a rate of 3-15 °C/h; and removing the platinum crucible, to obtain the nonlinear optical crystal of CsB₄O₆F.

The high temperature solution method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
b) mixing the polycrystal powder of the compound of CsB₄O₆F obtained from step a) homogeneously with a fluxing agent at a molar ratio of 1:0.1-0.5; then filling the mixture into a clean platinum crucible, and increasing the temperature to 400-700 °C at a rate of 35-45 °C/h for 7-15 hours, to give a meltsolution; wherein the Cs-containing compound is Cs₂CO₃, CsNO₃, CsHCO₃, CsF or CsBF₄; the F-containing compound is CsF or CsBF₄; the B-containing compound is H₃BO₃, B₂O₃ or CsBF₄; and the fluxing agent is CsF, H₃BO₃, B₂O₃, PbO or PbF₂;
c) preparation of a seed crystal: placing the meltsolution prepared in step b) into a single crystal furnace, and then decreasing the temperature to 350-610 °C at a rate of 0.1-5 °C/h, to 300-385 °C at a rate of 0.2-0.6 °C/h, and further to 30 °C at a rate of 3-10 °C/h, to give a seed crystal of CsB₄O₆F; and
d) growth of a crystal: fixing the resultant seed crystal of CsB₄O₆F onto a seed crystal rod; lowering the seed crystal to 1 mm above the liquid surface from the top of a crystal growing furnace for the meltsolution prepared in step b), and preheating it for 10-25 minutes; contacting the seed crystal with the liquid surface, and decreasing the temperature at a rate of 0.1-2 °C/h; upon completion of the crystal growth, pulling the crystal away from the surface of the solution, and then decreasing the temperature to 30 °C at a rate of 3-10 °C/h, to obtain the nonlinear optical crystal of CsB₄O₆F.

The vacuum encapsulation method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C at a rate of 10-50 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄; and
b) mixing the polycrystal powder of the compound of CsB₄O₆F obtained from step a) homogeneously with a fluxing agent at a molar ratio of 1:0.1-1; then filling the mixture into a quartz tube, and increasing the temperature to 400-700 °C at a rate of 10-50 °C/h for 3-96 hours; then decreasing the temperature to 330-450 °C at a rate of 0.5-1.5 °C/day, and further to 30 °C at a rate of 2-5 °C/h; and cutting the quartz tube to obtain the nonlinear optical crystal of CsB₄O₆F; wherein the Cs-containing compound is Cs₂CO₃, CsNO₃, CsHCO₃, CsF or CsBF₄; the F-containing compound is CsF, CsBF4 or HF; the B-containing compound is H₃BO₃, B₂O₃ or CsBF₄; and the fluxing agent is CsF, H₃BO₃, B₂O₃, PbO or PbF₂.

The hydrothermal method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder product of CsB₄O₆F; wherein the Cs-containing compound is Cs₂CO₃, CsNO₃, CsHCO₃, CsF or CH₃COOCs; the F-containing compound is CsF or HF; and the B-containing compound is H₃BO₃ or B₂O₃;
b) dissolving the polycrystal powder of the compound of CsB₄O₆F obtained from step a) in 5-30 mL of deionized water, and sonicating the incompletely dissolved mixture at a temperature of 20-50 °C for 5-30 minutes to allow for sufficient mixing and dissolution;
c) transferring the mixed solution obtained from step b) into the lining of a clean, pollution-free high pressure reactor with a volume of 100 mL, and tightening and sealing the reactor; and
d) placing the high pressure reactor in a thermostat, increasing the temperature to 150-350 °C at a rate of 5-50 °C/h for 3-15 days, and then decreasing the temperature to room temperature at a rate of 5-30 °C/day, to obtain the nonlinear optical crystal of CsB₄O₆F.

The room temperature solution method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder product of CsB₄O₆F; wherein the Cs-containing compound is Cs₂CO₃, CsNO₃, CsHCO₃, CsF or CH₃COOCs; the F-containing compound is CsF or HF; and the B-containing compound is H₃BO₃ or B₂O₃;
b) placing the polycrystal powder of the compound of CsB₄O₆F obtained from step a) in a clean glass container, to which 20-100 mL of deionized water is added, followed by ultrasonication for 5-60 minutes to allow for sufficient mixing and dissolution, and then adjusting the pH of the solution to 8-11 by addition of HF or CsOH;
c) sealing the container containing the solution in step b) with weighing paper, and placing it in a static environment without shaking, pollution and air convection; controlling the evaporation rate at 0.2-2 mL/day by piercing the seal; and setting it aside for 5-20 days at room temperature;
d) obtaining a seed crystal upon completion of the growth when the size of the crystal particles grown at the bottom of the container from the solution in step c) is no longer changed significantly; and
e) filtering the remaining solution through qualitative filter paper to filter out grains and other impurities from the solution; selecting the seed crystal of better quality, fixing it with a platinum wire and suspending it in the filtered solution; controlling the evaporation rate at 0.2-2 mL/day by piercing the seal, and setting it aside for growth for 5-20 days at room temperature, to obtain the nonlinear optical crystal of CsB₄O₆F.

The present invention provides the utilities of the nonlinear optical crystal of cesium fluorooxoborate in the manufacture of an Nd:YAG laser that outputs a fundamental frequency light of 1064 nm for the second, third, fourth, fifth or sixth harmonic generation laser output.

The present invention provides the utilities of the nonlinear optical crystal of cesium fluorooxoborate in the production of a deep-ultraviolet frequency-multiplied light output of below 200 nm.

The present invention provides the utilities of the nonlinear optical crystal of the compound of cesium fluorooxoborate in the manufacture of a frequency multiplication generator, a frequency up or down converter or an optical parametric oscillator.

In the method of preparing the nonlinear optical crystal of cesium fluorooxoborate according to the present invention, the polycrystal powder of cesium fluorooxoborate for use in the preparation of the melt or mixed solution can also be replaced by raw materials which are directly weighed; that is, the Cs-containing compound, B-containing compound and F-containing compound can be weighed and mixed homogeneously at a molar ratio of Cs: B: F = 0.5-2: 3-5: 0.5-2; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄.

In the method for preparing the nonlinear optical crystal of cesium fluorooxoborate according to the present invention, the container used during the preparation is a platinum crucible, iridium crucible, ceramic crucible, quartz tube, conical flask, beaker, or hydrothermal reactor lined with polytetrafluoroethylene or lined with stainless steel with a platinum sleeve. When the container is a quartz tube, vacuumization is required before sealing to avoid burst of the quartz tube resulting from volatilization of the raw materials in the reaction. When the container is a conical flask or beaker, it needs to be washed with an acid, rinsed with deionized water, and air-dried.

In the method of preparing the nonlinear optical crystal of cesium fluorooxoborate according to the present invention, the resistance furnace used during the preparation is a muffle furnace or drying cabinet.

With the method for preparing the nonlinear optical crystal of cesium fluorooxoborate according to the present invention, a centimeter-sized nonlinear optical crystal of CsB₄O₆F can be obtained. When a large-sized crucible or container is used and the growth cycle of the crystal is prolonged, a corresponding large-sized nonlinear optical crystal of CsB₄O₆F can be obtained. During the growth of the nonlinear optical crystal of CsB₄O₆F, the crystal is easy to grow up without inclusions and has high transparency, and has the advantages of high growth rate, low cost, easy to obtain large-sized crystals, and so on.

The large-sized nonlinear optical crystal of CsB₄O₆F obtained by the method for preparing the nonlinear optical crystal of cesium fluorooxoborate according to the present invention can be used as a nonlinear optical device by orienting the raw crystal based on the crystallographic data of the crystal, cutting the crystal according to the desired angle, thickness and sectional size, and polishing the transmission surface of the crystal. The nonlinear optical crystal of CsB₄O₆F has the advantages of a wide transparent region, stable physical and chemical properties, a high mechanical hardness, being hard to break and deliquesce, being easy to cut, polish and preserve, and so on.

### BRIEF DESCRIPTION OF THE DRAWINGS

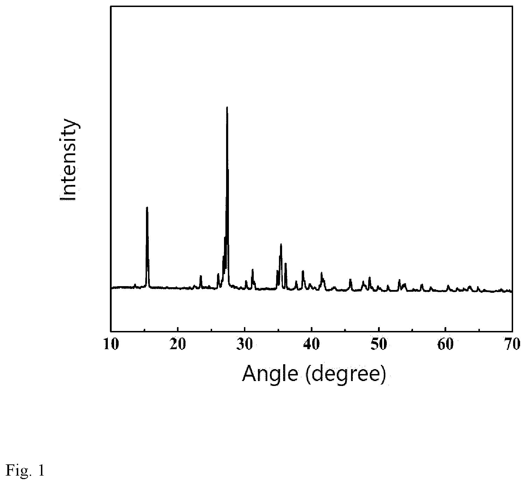

Fig. 1 shows a powder XRD pattern of the compound of CsB₄O₆F of the present invention, which is consistent with the theoretical XRD pattern, demonstrating the presence of the compound of CsB₄O₆F.
Fig. 2 shows the structure of the CsB₄O₆F crystal of the present invention.
Fig. 3 illustrates the operating principle of the nonlinear optical device made of the CsB₄O₆F crystal of the present invention, wherein 1 represents a laser, 2 represents an emitted beam, 3 represents a CsB₄O₆F crystal, 4 represents an outgoing beam, and 5 represents a filter.

### DETAILED DESCRIPTION OF THE INVENTION

The present invention is further described with reference to the following Examples. It should be understood that the present invention is not limited to the Examples illustrated below. The raw materials and equipments used herein are all commercially available unless otherwise indicated.

### Example 1: Preparation of a compound

The compound of CsB₄O₆F was synthesized by the solid-state synthesis method based on the reaction equation CsF+2B₂O₃→CsB₄O₆F.

CsF and B₂O₃ were mixed homogeneously at a molar ratio of 1:3. CsF and H₃BO₃ were mixed homogeneously at a molar ratio of 2:5. The mixtures were filled into a clean, pollution-free platinum crucible with a volume of 28 mL. The temperature was then increased to 350 °C for 96 hours, to obtain the compound of CsB₄O₆F.

### Example 2: Preparation of a compound

The compound of CsB₄O₆F was synthesized by the solid-state reaction method based on the reaction equation CsF+4H₃BO₃→CsB₄O₆F+6H₂O↑.

CsF and H₃BO₃ were mixed homogeneously at a molar ratio of 2:5, and filled into a clean, pollution-free platinum crucible with a volume of 28 mL. The temperature was then increased to 600 °C for 3 hours, to obtain the compound of CsB₄O₆F.

### Example 3: Preparation of a compound

The compound of CsB₄O₆F was synthesized by the solid-state reaction method based on the reaction equation 12CsHCO₃ + 4CsBF₄ → CsB₄O₆F + 15CsF + 6H₂O↑ + 12CO₂↑.

CsHCO₃ and CsBF₄ were mixed homogeneously at a molar ratio of 2:3, and filled into a platinum crucible. The platinum crucible was placed in a muffle furnace, and the temperature was then increased to 450 °C for 56 hours, to obtain the compound of CsB₄O₆F.

### Example 4: Preparation of a compound

The compound of CsB₄O₆F was synthesized by the solid-state reaction method based on the reaction equation 6Cs₂CO₃ + 4CsBF₄ → CsB₄O₆F + 15CsF + 6CO₂↑.

Cs₂CO₃ and CsBF₄ were mixed homogeneously at a molar ratio of 2:3, and filled into a platinum crucible. The platinum crucible was placed in a muffle furnace, and the temperature was then increased to 460 °C for 96 hours, to obtain the compound of CsB₄O₆F.

### Example 5: Preparation of a compound

The compound of CsB₄O₆F was synthesized by the solid-state synthesis method based on the reaction equation 12CsNO₃ + 4CsBF₄ → CsB₄O₆F + 15CsF + 6N₂O₅.

CsNO₃ and CsBF₄ were mixed homogeneously at a molar ratio of 2:3, and filled into a platinum crucible. The platinum crucible was placed in a muffle furnace, and the temperature was then increased to 470 °C for 96 hours, to obtain the compound of CsB₄O₆F.

### Example 6: Preparation of a compound

The compound of CsB₄O₆F was synthesized by the vacuum encapsulation method based on the reaction equation CsF+2B₂O₃→CsB₄O₆F.

CsF and B₂O₃ were mixed homogeneously at a molar ratio of 1:3, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was then increased to 350 °C at a rate of 50 °C for 96 hours. The quartz tube was opened after the temperature was decreased to room temperature, to obtain the compound of CsB₄O₆F.

### Example 7: Preparation of a compound

The compound of CsB₄O₆F was synthesized by the vacuum encapsulation method based on the reaction equation CsF+4H₃BO₃→CsB₄O₆F+6H₂O↑

CsF and B₂O₃ were mixed homogeneously at a molar ratio of 2:5, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was then increased to 600 °C at a rate of 10 °C for 96 hours. The quartz tube was opened after the temperature was decreased to room temperature, to obtain the compound of CsB₄O₆F.

### Example 8: Preparation of a compound

The compound of CsB₄O₆F was synthesized by the vacuum encapsulation method based on the reaction equation 12CsHCO₃ + 4CsBF₄ → CsB₄O₆F + 15CsF + 6H₂O↑ + 12CO₂↑.

CsHCO₃ and CsBF₄ were mixed homogeneously at a molar ratio of 2:3, and filled into a Φ40 mm quartz tube. The quartz tube was vacuumized to a vacuum degree of 1×10⁻³ Pa, and sealed at an elevated temperature. Then, the quartz tube was placed in a muffle furnace, and the temperature was increased to 470 °C at a rate of 6 °C/h for 72 hours, to obtain the compound of CsB₄O₆F.

### Example 9: Preparation of a compound

The compound of CsB₄O₆F was synthesized by the vacuum encapsulation method based on the reaction equation 6Cs₂CO₃ + 4CsBF₄ → CsB₄O₆F + 15CsF + 6CO₂↑.

Cs₂CO₃ and CsBF₄ were mixed homogeneously at a molar ratio of 2:3, and filled into a Φ40 mm quartz tube. The quartz tube was vacuumized to a vacuum degree of 1×10⁻³ Pa, and sealed at an elevated temperature. Then, the quartz tube was placed in a muffle furnace, and the temperature was increased to 460 °C at a rate of 5 °C/h for 72 hours, to obtain the compound of CsB₄O₆F.

### Example 10: Preparation of a compound

The compound of CsB₄O₆F was synthesized by the vacuum encapsulation method based on the reaction equation 12CsNO₃ + 4CsBF₄ → CsB₄O₆F + 15CsF + 6N₂O₅.

CsNO₃ and CsBF₄ were mixed homogeneously at a molar ratio of 2:3, and filled into a Φ40 mm quartz tube. The quartz tube was vacuumized to a vacuum degree of 1×10⁻³ Pa, and sealed at an elevated temperature. Then, the quartz tube was placed in a muffle furnace, and the temperature was increased to 450 °C at a rate of 4 °C/h for 72 hours, to obtain the compound of CsB₄O₆F.

### Example 11: Synthesis of a nonlinear optical crystal of CsB₄O₆F by the high temperature solution method

The compound of CsB₄O₆F obtained in accordance with Example 1 was mixed homogeneously with CsF as a fluxing agent at a molar ratio of 1:0.1, and filled into a clean platinum crucible. The platinum crucible was placed in a single crystal growing furnace, and the temperature was then increased to 400 °C at a rate of 35 °C/h for 7 hours, to give a mixedsolution.

Preparation of a seed crystal: the mixed solution as prepared was placed in a single crystal furnace, and the temperature was decreased to 350 °C at a rate of 0.1 °C/h, to 300 °C at a rate of 0.2 °C/h, and further to 30 °C at a rate of 3 °C/h, to give a seed crystal of CsB₄O₆F.

Growth of a crystal: the seed crystal of CsB₄O₆F obtained above was fixed on a seed crystal rod. The seed crystal was lowered to 1 mm above the liquid surface from the top of a crystal growing furnace containing the mixed solution as prepared, and preheated for 10 minutes. Then, the seed crystal was contacted with the liquid surface, and the temperature was decreased at a rate of 0.1 °C/h. Upon completion of the crystal growth, the crystal on the seed crystal rod was pulled out, and the temperature was decreased to 30 °C at a rate of 3 °C/h, to obtain a nonlinear optical crystal of CsB₄O₆F with a size of 12 mm×13 mm×16 mm.

### Example 12: Synthesis of a nonlinear optical crystal of CsB₄O₆F by the high temperature solution method

The compound of CsB₄O₆F obtained in accordance with Example 2 was mixed with PbF₂ as a fluxing agent at a molar ratio of 1:0.5. The mixture was placed in a single crystal growing furnace, and the temperature was then increased to 700 °C at a rate of 45 °C/h for 15 hours, to give a mixed solution.

Preparation of a seed crystal: the solution as prepared was placed in a single crystal furnace, and the temperature was decreased to 610 °C at a rate of 5 °C/h, to 385 °C at a rate of 0.6 °C/h, and further to 30 °C at a rate of 10 °C/h, to give a seed crystal of CsB₄O₆F.

Growth of a crystal: the seed crystal of CsB₄O₆F obtained above was fixed on a seed crystal rod. The seed crystal was lowered to 1 mm above the liquid surface from the top of a crystal growing furnace containing the mixed solution as prepared, and preheated for 25 minutes. Then, the seed crystal was contacted with the liquid surface, and the temperature was decreased at a rate of 2 °C/h. Upon completion of the crystal growth, the crystal on the seed crystal rod was pulled out, and the temperature was decreased to 30 °C at a rate of 10 °C/h, to obtain a nonlinear optical crystal of CsB₄O₆F with a size of 15 mm×17 mm×18 mm.

Example 13: Synthesis of a nonlinear optical crystal of CsB₄O₆F by the high temperature solution method.

The compound of CsB₄O₆F obtained in accordance with Example 3 was mixed with B₂O₃ as a fluxing agent at a molar ratio of 1:0.5, and filled into a clean platinum crucible. The platinum crucible was placed in a single crystal growing furnace, and the temperature was increased to 690 °C at a rate of 40 °C/h for 10 hours, to give a mixed solution.

Preparation of a seed crystal: the mixed solution as prepared was placed in the single crystal furnace, and the temperature was decreased to 580 °C at a rate of 3 °C/h, to 330 °C at a rate of 0.6 °C/h, and further to 30 °C at a rate of 8 °C/h, to give a seed crystal of CsB₄O₆F.

Growth of a crystal: the seed crystal of CsB₄O₆F obtained above was fixed on a seed crystal rod. The seed crystal was lowered to 1 mm above the liquid surface from the top of a crystal growing furnace containing the mixed solution as prepared, and preheated for 20 minutes. Then, the seed crystal was contacted with the liquid surface, and the temperature was decreased at a rate of 0.3 °C/h. Upon completion of the crystal growth, the crystal on the seed crystal rod was pulled out, and the temperature was decreased to 30 °C at a rate of 8 °C/h, to obtain a nonlinear optical crystal of CsB₄O₆F with a size of 12 mm×15 mm×19 mm.

### Example 14: Synthesis of a nonlinear optical crystal of CsB₄O₆F by the high temperature solution method

The compound of CsB₄O₆F obtained in accordance with Example 4 was mixed with PbO as a fluxing agent at a molar ratio of 1:0.2, and filled into a platinum crucible. The platinum crucible was placed in a single crystal growing furnace, and the temperature was then increased to 660 °C at a rate of 35 °C/h for 8 hours, to give a mixed solution.

Preparation of a seed crystal: the solution as prepared was placed in a single crystal furnace, and the temperature was decreased to 575 °C at a rate of 2 °C/h, to 380 °C at a rate of 0.2 °C/h, and further to 30 °C at a rate of 7 °C/h, to give a seed crystal of CsB₄O₆F.

Growth of a crystal: the seed crystal of CsB₄O₆F obtained above was fixed on a seed crystal rod. The seed crystal was lowered to 1 mm above the liquid surface from the top of a crystal growing furnace containing the mixed solution as prepared, and preheated for 25 minutes. Then, the seed crystal was contacted with the liquid surface, and the temperature was decreased at a rate of 0.1 °C/h. Upon completion of the crystal growth, the crystal on the seed crystal rod was pulled out, and the temperature was decreased to 30 °C at a rate of 7 °C/h, to obtain a nonlinear optical crystal of CsB₄O₆F with a size of 10 mm×12 mm×15 mm.

### Example 15: Synthesis of a nonlinear optical crystal of CsB₄O₆F by the high temperature solution method

The raw materials were weighed at a molar ratio of CsF:H₃BO₃=1:4, and mixed with H₃BO₃ as a fluxing agent at a molar ratio of 1:0.4. The mixture was filled into a platinum crucible. The platinum crucible was placed in a single crystal growing furnace, and the temperature was then increased to 665 °C at a rate of 37 °C/h for 7 hours, to give a mixed solution.

Preparation of a seed crystal: the mixed solution as prepared was placed in a single crystal furnace, and the temperature was decreased to 570 °C at a rate of 2.4 °C/h, to 385 °C at a rate of 0.15 °C/h, and further to 30 °C at a rate of 7.5 °C/h, to give a seed crystal of CsB₄O₆F.

Growth of a crystal: the seed crystal of CsB₄O₆F obtained above was fixed on a seed crystal rod. The seed crystal was lowered to 1 mm above the liquid surface from the top of a crystal growing furnace containing the mixed solution as prepared, and preheated for 20 minutes. Then, the seed crystal was contacted with the liquid surface, and the temperature was decreased at a rate of 0.15 °C/h. Upon completion of the crystal growth, the crystal on the seed crystal rod was pulled out, and the temperature was further decreased to 30 °C at a rate of 7.5 °C/h, to obtain a nonlinear optical crystal of CsB₄O₆F with a size of 13 mm×14 mm×16 mm.

### Example 16: Growth of a CsB₄O₆F crystal by the vacuum encapsulation method

The compound of CsB₄O₆F obtained in accordance with Example 6 was mixed with B₂O₃ as a fluxing agent at a molar ratio of 1:0.1, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was increased to 400 °C at a rate of 10 °C/h for 3 hours. Then, the temperature was decreased to 330 °C at a rate of 0.5 °C/day, and further to 30 °C at a rate of 2 °C/h. The quartz tube was cut apart to obtain a nonlinear optical crystal of CsB₄O₆F with a size of 13 mm×16 mm×21 mm.

### Example 17: Growth of a CsB₄O₆F crystal by the vacuum encapsulation method

The compound of CsB₄O₆F obtained in accordance with Example 7 was mixed with CsF as a fluxing agent at a molar ratio of 1:1, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was increased to 700 °C at a rate of 50 °C/h for 96 hours. Then, the temperature was decreased to 450 °C at a rate of 1.5 °C/day, and further to 30 °C at a rate of 5 °C/h. The quartz tube was cut apart to obtain a nonlinear optical crystal of CsB₄O₆F with a size of 15 mm×18 mm×23 mm.

### Example 18: Growth of a CsB₄O₆F crystal by the vacuum encapsulation method

The compound of CsB₄O₆F obtained in accordance with Example 8 was mixed with H₃BO₃ as a fluxing agent at a molar ratio of 1:0.3, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was increased to 500 °C at a rate of 35 °C/h for 50 hours. Then, the temperature was decreased to 430 °C at a rate of 0.5 °C/day, and further to 30 °C at a rate of 4 °C/h. The quartz tube was cut apart to obtain a nonlinear optical crystal of CsB₄O₆F with a size of 14 mm×16 mm×17 mm.

### Example 19: Growth of a CsB₄O₆F crystal by the vacuum encapsulation method

The compound of CsB₄O₆F obtained in accordance with Example 9 was mixed with PbO as a fluxing agent at a molar ratio of 1:0.4, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was increased to 520 °C at a rate of 32 °C/h for 52 hours. Then, the temperature was decreased to 435 °C at a rate of 0.8 °C/day, and further to 30 °C at a rate of 4.5 °C/h. The quartz tube was cut apart to obtain a nonlinear optical crystal of CsB₄O₆F with a size of 14 mm×16 mm×17 mm.

### Example 20: Growth of a CsB₄O₆F crystal by the vacuum encapsulation method

The raw materials were weighed according to CsF:H₃BO₃=1:4. The compound of CsB₄O₆F thus obtained was mixed with PbF₂ as a fluxing agent at a molar ratio of 1:0.5, and filled into a Φ40 mm quartz tube. The quartz tube was vacuumized to a vacuum degree of 1×10⁻³ Pa, and vacuum encapsulated with a flame gun. The quartz tube was placed in a muffle furnace, and the temperature was increased to 510 °C at a rate of 37 °C/h for 96 hours. Then, the temperature was decreased to 445 °C at a rate of 1.2 °C/day, and further to 30 °C at a rate of 3.5 °C/h. The quartz tube was cut apart to obtain a nonlinear optical crystal of CsB₄O₆F with a size of 14 mm×16 mm×17 mm.

### Example 21: Synthesis of a nonlinear optical crystal of CsB₄O₆F by the Czochralski method.

The compound of CsB₁₀O₆F obtained in accordance with Example 10 was filled into a clean platinum crucible. The platinum crucible was placed in a muffle furnace, and the temperature was increased to 700 °C at a rate of 40 °C/h for 15 hours, to give a melt.

The temperature of the melt obtained above was decreased to 590 °C at a rate of 5 °C/h, to 440 °C at a rate of 2 °C/h, and further to 30 °C at a rate of 15 °C/h, to give a seed crystal of CsB₄O₆F.

The seed crystal of CsB₄O₆F obtained above was fixed on a seed crystal rod. The seed crystal was lowered to 1 mm above the liquid surface from the top of a crystal growing furnace containing the melt as prepared, and preheated for 5 minutes. The seed crystal was then immersed in the liquid at 5 mm below the surface, and rotated at 30 rpm by a crystal growth controller. The melt was saturated by controlling the temperature, and the seed crystal was lifted at a rate of 3 mm/day while the temperature was kept constant. Upon completion of the crystal growth, the crystal on the seed crystal rod was pulled out, and the temperature was decreased to 440 °C at a rate of 2 °C/h, and further to 30 °C at a rate of 15 °C/h, to obtain a nonlinear optical crystal of CsB₄O₆F with a size of 12 mm×15 mm×16 mm.

### Example 22: Synthesis of a nonlinear optical crystal of CsB₄O₆F by the Czochralski method

The compound of CsB₂O₆F obtained in accordance with Example 2 was filled into a platinum crucible. The platinum crucible was placed in a single crystal growing furnace, and the temperature was increased to 400 °C at a rate of 20 °C/h for 7 hours, to give a melt.

The temperature of the melt obtained above was decreased to 400 °C at a rate of 0.1 °C/h, to 300 °C at a rate of 0.2 °C/h, and further to 30 °C at a rate of 3 °C/h, to give a seed crystal of CsB₄O₆F.

The seed crystal of CsB₄O₆F obtained above was fixed on a seed crystal rod. The seed crystal was lowered to 1 mm above the liquid surface from the top of a crystal growing furnace containing the melt as prepared, and preheated for 5 minutes. The seed crystal was then immersed in the liquid at 1 mm below the surface, and rotated at 2 rpm by a crystal growth controller. The melt was saturated by controlling the temperature, and the seed crystal was lifted at a rate of 1 mm/day while the temperature was kept constant. Upon completion of the crystal growth, the crystal on the seed crystal rod was pulled out, and the temperature was decreased to 300 °C at a rate of 0.2 °C/h, and further to 30 °C at a rate of 3 °C/h, to obtain a nonlinear optical crystal of CsB₄O₆F with a size of 11 mm×14 mm×15 mm.

Example 23: Synthesis of a nonlinear optical crystal of CsB₄O₆F by the Czochralski method The raw materials were weighed according to CsF:H₃BO₃=1:4, and filled into a clean platinum crucible. The platinum crucible was placed in a muffle furnace, and the temperature was increased to 650 °C at a rate of 30 °C/h for 12 hours, to give a melt.

The temperature of the melt obtained above was decreased to 580 °C at a rate of 4 °C/h, to 440 °C at a rate of 1 °C/h, and further to 30 °C at a rate of 6 °C/h, to give a seed crystal of CsB₄O₆F.

The Seed crystal of CsB₄O₆F obtained above was fixed on a seed crystal rod. The seed crystal was lowered to 1 mm above the liquid surface from the top of a crystal growing furnace containing the melt as prepared, and preheated for 15 minutes. The seed crystal was then immersed in the liquid at 3 mm below the surface, and rotated at 8 rpm by a crystal growth controller. The melt was saturated by controlling the temperature, and the seed crystal was lifted at a rate of 3 mm/day while the temperature was kept constant. Upon completion of the crystal growth, the crystal on the seed crystal rod was pulled out, and the temperature was decreased to 440 °C at a rate of 1 °C/h, and further to 30 °C at a rate of 6 °C/h, to obtain a nonlinear optical crystal of CsB₄O₆F with a size of 17 mm×19 mm×20 mm.

### Example 24: Growth of a CsB₄O₆F crystal by the Bridgman-Stockbarger Method

The compound of CsB₄O₆F obtained in accordance with Example 4 was filled into a platinum crucible. The platinum crucible was placed in a single crystal growing furnace, and the temperature was increased to 700 °C at a rate of 20 °C/h for 15 hours, to give a melt.

The temperature of the melt obtained above was decreased to 590 °C at a rate of 5 °C/h, to 440 °C at a rate of 2 °C/h, and further to 30 °C at a rate of 15 °C/h. The platinum crucible was removed to give a seed crystal of CsB₄O₆F.

The seed crystal obtained above was placed at the bottom of the platinum crucible, and then the compound of CsB₄O₆F obtained was also placed in the platinum crucible. The platinum crucible was sealed and placed in a Bridgman-Stockbarger furnace, and the temperature was increased to 700 °C for 15 hours. The position of the platinum crucible was adjusted such that the seeding temperature was 625 °C. Then, the platinum crucible was lowered at a rate of 10 mm/day while the growth temperature was kept constant. Upon completion of the growth, the temperature was decreased to 440 °C at a rate of 2 °C/h, and further to 30 °C at a rate of 15 °C/h. The platinum crucible was removed to obtain a nonlinear optical crystal of CsB₄O₆F with a size of 18 mm×23 mm×24 mm.

### Example 25: Growth of a CsB₄O₆F crystal by the Bridgman-Stockbarger Method

The compound of CsB₅O₆F obtained in accordance with Example 5 was filled into a platinum crucible. The platinum crucible was placed in a single crystal growing furnace, and the temperature was increased to 675 °C at a rate of 40 °C/h for 7 hours, to give a melt.

The temperature of the melt obtained above was decreased to 575 °C at a rate of 0.1 °C/h, to 380 °C at a rate of 1.5 °C/h, and further to 30 °C at a rate of 12 °C/h. The platinum crucible was removed to give a seed crystal of CsB₄O₆F.

The seed crystal obtained above was placed at the bottom of the platinum crucible, and then the compound of CsB₄O₆F obtained was also placed in the platinum crucible. The platinum crucible was sealed and placed in a Bridgman-Stockbarger furnace, and the temperature was then increased to 500 °C for 7 hours. The position of the platinum crucible was adjusted such that the seeding temperature was 500 °C. Then, the platinum crucible was lowered at a rate of 1 mm/day while the growth temperature was kept constant. Upon completion of the growth, the temperature was decreased to 300 °C at a rate of 0.2 °C/h, and further to 30 °C at a rate of 3 °C/h. The platinum crucible was removed to obtain a nonlinear optical crystal of CsB₄O₆F with a size of 19 mm×22 mm×23 mm.

### Example 26: Growth of a CsB₄O₆F crystal by the Bridgman-Stockbarger Method

The raw materials were weighed according to CsF:B₂O₃=1:2, and filled into a platinum crucible. The platinum crucible was placed in a muffle furnace, and the temperature was increased to 680 °C at a rate of 30 °C/h for 24 hours, to give a melt.

The temperature of the melt obtained above was decreased to 570 °C at a rate of 3 °C/h, to 350 °C at a rate of 1 °C/h, and further to 30 °C at a rate of 15 °C/h. The platinum crucible was removed to give a seed crystal of CsB₄O₆F.

The seed crystal obtained above was placed at the bottom of the platinum crucible, and then the compound of CsB₄O₆F obtained was also placed in the platinum crucible. The platinum crucible was sealed and placed in a Bridgman-Stockbarger furnace, and the temperature was increased to 680 °C for 12 hours. The position of the platinum crucible was adjusted such that the seeding temperature was 550 °C. Then, the platinum crucible was lowered at a rate of 5 mm/day while the growth temperature was kept constant. Upon completion of the growth, the temperature was decreased to 350 °C at a rate of 1 °C/h, and further to 30 °C at a rate of 15 °C/h. The platinum crucible was removed to obtain a nonlinear optical crystal of CsB₄O₆F with a size of 15 mm×16 mm×23 mm.

### Example 27: Synthesis of a nonlinear optical crystal of CsB₄O₆F by the Kyropoulos method.

The compound of CsB₂O₆F obtained in accordance with Example 2 was filled into a platinum crucible. The platinum crucible was placed in a single crystal growing furnace, and the temperature was increased to 630 °C at a rate of 40 °C/h for 18 hours, to give a melt.

The temperature of the melt obtained above was decreased to 565 °C at a rate of 5 °C/h, to 380 °C at a rate of 2 °C/h, and further to 30 °C at a rate of 8 °C/h, to give a seed crystal of CsB₄O₆F.

The seed crystal of CsB₄O₆F obtained above was fixed on a seed crystal rod. The seed crystal was lowered to 1 mm above the liquid surface from the top of a crystal growing furnace containing the melt as prepared, and preheated for 60 minutes. The seed crystal was then immersed in the liquid at 5 mm below the surface, and the temperature was decreased at a rate of 0.7 °C/h. 3 hours later, the seed crystal was lifted by 2 mm. The temperature was further decreased at a rate of 0.7 °C/h. Upon completion of the crystal growth, the crystal on the seed crystal rod was pulled out, and the temperature was decreased to 440 °C at a rate of 2 °C/h, and further to 30 °C at a rate of 15 °C/h, to obtain a nonlinear optical crystal of CsB₄O₆F with a size of 4 mm×6 mm×9 mm.

### Example 28: Synthesis of a nonlinear optical crystal of CsB₄O₆F by the Kyropoulos method

The compound of CsB₃O₆F obtained in accordance with Example 3 was filled into a platinum crucible. The platinum crucible was placed in a single crystal growing furnace, and the temperature was increased to 640 °C at a rate of 20 °C/h for 24 hours, to give a melt.

The temperature of the melt obtained above was decreased to 560 °C at a rate of 6 °C/h, to 390 °C at a rate of 1.8 °C/h, and further to 30 °C at a rate of 3.5 °C/h, to give a seed crystal of CsB₄O₆F.

The crystal was grown in the melt of the compound by the Kyropoulos method as below. The seed crystal of CsB₄O₆F obtained above was fixed on a seed crystal rod. The seed crystal was lowered to 1 mm above the liquid surface from the top of a crystal growing furnace containing the melt as prepared, and preheated for 5 minutes. The seed crystal was then immersed in the liquid at 1 mm below the surface, and the temperature was decreased at a rate of 0.1 °C/h. 10 hours later, the seed crystal was lifted by 1 mm, and the temperature was further decreased at a rate of 0.1 °C/h. Upon completion of the crystal growth, the crystal on the seed crystal rod was pulled out, and the temperature was decreased to 300 °C at a rate of 0.2 °C/h, and further to 30 °C at a rate of 3 °C/h, to obtain a nonlinear optical crystal of CsB₄O₆F with a size of 13 mm×18 mm×24 mm.

### Example 29: Synthesis of a nonlinear optical crystal of CsB₄O₆F by the room temperature solution method

The compound of CsB₄O₆F obtained in accordance with Example 1 was put into a clean glass container, to which 100 mL of deionized water was added. Then, ultrasonication was performed for 5 minutes to allow for sufficient mixing and dissolution. Then, the pH of the solution was adjusted to 8 by addition of HF or CsOH.

The container containing the solution was sealed with weighing paper and placed in a static environment without shaking, pollution and air convection. The evaporation rate was controlled at 2 mL/day by piercing the seal, and the solution was set aside for 5 days.

Crystal particles were grown at the bottom of the container from the solution. Upon completion of the growth when the size of the crystal particles was no longer changed significantly, a seed crystal was obtained.

The remaining solution was filtered with qualitative filter paper to filter out grains and other impurities from the solution. The seed crystal of better quality was selected, fixed with a platinum wire and suspended in the filtered solution. The evaporation rate was controlled at 2 mL/day by piercing the seal. The solution was set aside for 30 days at room temperature, to obtain a nonlinear optical crystal of CsB₄O₆F with a size of 8 mm×14 mm×17 mm.

### Example 30: Synthesis of a nonlinear optical crystal of CsB₄O₆F by the room temperature solution method

The raw materials were weighed according to CsF:B₂O₃=1:2, and put into a clean glass container, to which 20 mL of deionized water was added. Then, ultrasonication was performed for 30 minutes to allow for sufficient mixing and dissolution. Then, the pH of the solution was adjusted to 11 by addition of HF or CsOH.

The container containing the solution was sealed with weighing paper and placed in a static environment without shaking, pollution and air convection. The evaporation rate was controlled at 0.2 mL/day by piercing the seal, and the solution was set aside for 20 days.

Crystal particles were grown at the bottom of the container from the solution. Upon completion of the growth when the size of the crystal particles was no longer changed significantly, a seed crystal was obtained.

The remaining solution was filtered with qualitative filter paper to filter out grains and other impurities from the solution. The seed crystal was fixed with a platinum wire and suspended in the filtered solution. The evaporation rate was controlled at 0.2 mL/day by piercing the seal. The solution was set aside for 30 days at room temperature, to obtain a nonlinear optical crystal of CsB₄O₆F with a size of 4 mm×8 mm×9 mm.

### Example 31: Synthesis of a nonlinear optical crystal of CsB₄O₆F by the hydrothermal method

The compound of CsB₄O₆F obtained in accordance with Example 1 was added to 5 mL of deionized water. The incompletely dissolved mixture was sonicated at a temperature of 20 °C for 5 minutes to allow for sufficient mixing.

The mixed solution was transferred into the lining of a clean, pollution-free high pressure reactor with a volume of 100 mL, and the reactor was tightened and sealed.

The high pressure reactor was placed in a thermostat, and the temperature was increased to 350 °C at a rate of 50 °C/h for 3 days. Then, the temperature was decreased to room temperature at a rate of 5 °C/day. The high pressure reactor was opened to obtain a nonlinear optical crystal of CsB₄O₆F with a size of 8 mm×9 mm×15 mm.

### Example 32: Synthesis of a nonlinear optical crystal of CsB₄O₆F by the hydrothermal method

The raw materials were weighed according to CsF:H₃BO₃=1:4, and added to 30 mL of deionized water. The incompletely dissolved mixture was sonicated at a temperature of 50 °C for 30 minutes to allow for sufficient mixing.

The mixed solution was transferred into the lining of a clean, pollution-free high pressure reactor with a volume of 100 mL, and the reactor was tightened and sealed.

The high pressure reactor was placed in a thermostat, and the temperature was increased to 150 °C at a rate of 5 °C/h for 15 days. Then, the temperature was decreased to room temperature at a rate of 30 °C/day. The high pressure reactor was opened to obtain a nonlinear optical crystal of CsB₄O₆F with a size of 22 mm×24 mm×27 mm.

### Example 33: Synthesis of a nonlinear optical crystal of CsB₄O₆F by the hydrothermal method.

The compound of CsB₄O₆F obtained in accordance with Example 2 was added to 8 mL of deionized water. The incompletely dissolved mixture was sonicated at a temperature of 45 °C for 30 minutes to allow for sufficient mixing.

The mixture was transferred into the lining of a clean, pollution-free high pressure reactor with a volume of 100 mL, and the reactor was tightened and sealed.

The high pressure reactor was placed in a thermostat, and the temperature was increased to 330 °C at a rate of 40 °C/h for 10 days. Then, the temperature was decreased to room temperature at a rate of 8 °C/day. The high pressure reactor was opened to obtain a nonlinear optical crystal of CsB₄O₆F with a size of 12 mm×18 mm×20 mm.

### Example 34:

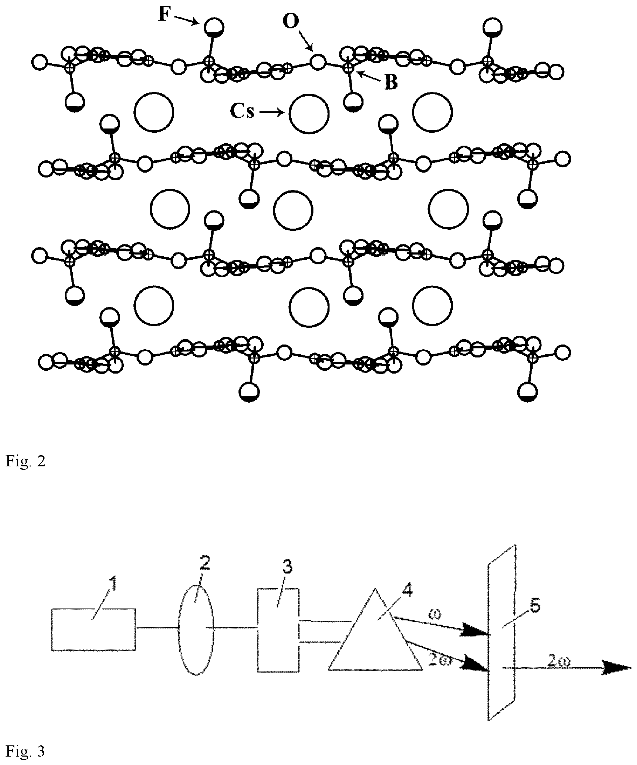

The CsB₄O₆F crystal obtained from any one of Examples 1-33 was processed in the phase-matched direction and was arranged in the position of 3 as shown in Fig. 3. At room temperature, a Q switched Nd:YAG laser was used as the light source with an fundamental wavelength of 1064 nm. The Q switched Nd:YAG laser 1 emitted an infrared beam 2 with a wavelength of 1064 nm onto the CsB₄O₆F single crystal 3, producing a green frequency-multiplied light with a wavelength of 532 nm, with an output intensity that is about 2 times that of KDP under the equivalent condition.

### Example 35:

The CsB₄O₆F crystal obtained from any one of Examples 1-33 was processed in the phase-matched direction, and was arranged in the position of 3 as shown in Fig. 3. At room temperature, a Q switched Nd:YAG laser was used as the light source with an incident wavelength of 532 nm. The Q switched Nd:YAG laser 1 emitted an infrared beam 2 with a wavelength of 532 nm onto the CsB₄O₆F single crystal 3, producing a frequency-multiplied light with a wavelength of 266 nm, with an output intensity that is about 0.5 times that of BBO under the equivalent condition.

### Example 36:

The CsB₄O₆F crystal obtained from any one of Examples 1-33 was processed in the phase-matched direction, and was arranged in the position of 3 as shown in Fig. 3. At room temperature, a Q switched Nd:YAG laser was used as the light source with an incident wavelength of 355 nm. The Q switched Nd:YAG laser 1 emitted an infrared beam 2 with a wavelength of 355 nm onto the CsB₄O₆F single crystal 3. An output of a deep-ultraviolet frequency-multiplied light with a wavelength of 177.3 nm could be observed.

## Claims

1. A compound of cesium fluorooxoborate, wherein a chemical formula of the compound is CsB₄O₆F, and a molecular weight of the compound is 291.15.

2. A method for preparing a compound of cesium fluorooxoborate of claim 1, wherein the compound is prepared by a solid-state synthesis method or a vacuum encapsulation method;
the said solid-state synthesis method for preparing of the compound of cesium fluorooxoborate comprises the steps of:
mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄; and
the said vacuum encapsulation method for preparing the compound of cesium fluorooxoborate,
mixing a Cs-containing compound, a B-containing compound and an F-containing compound homogeneously at a molar ratio of Cs:B:F=0.5-2:3-5:0.5-2; filling the mixture into a Φ40 mm quartz tube; vacuumizing the quartz tube to a vacuum degree of 1×10⁻³ Pa, and sealing it at a high temperature; then placing the quartz tube in a muffle furnace, and increasing the temperature to 350-600 °C at a rate of 10-50 °C for 3-96 hours, to give the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄.

3. A nonlinear optical crystal of cesium fluorooxoborate, wherein a chemical formula of the crystal is CsB₄O₆F and a molecular weight of the crystal is 291.15, and the crystal belongs to an orthorhombic crystal system, with a space group of *Pna2₁,* crystal cell parameters of *a*=7.9241Å, *b*=11.3996Å, *c*=6.6638Å, and *α*=*β*=*γ*=90°, and a unit cell volume of 601.95Å³.

4. A method for preparing the nonlinear optical crystal of cesium fluorooxoborate of claim 3, wherein the crystal is grown by a melt method, high temperature solution method, vacuum encapsulation method, hydrothermal method or room temperature solution method; wherein
the melt method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
b) filling the resultant polycrystal powder of the compound of CsB₄O₆F into a clean platinum crucible; placing the platinum crucible in a muffle furnace, and increasing the temperature to 400-700 °C at a rate of 20-40 °C/h for 7-15 hours, to give a melt; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
c) decreasing the temperature of the melt from step b) to 400-590 °C at a rate of 0.1-5 °C/h, to 300-440 °C at a rate of 0.2-2 °C/h, and further to 30 °C at a rate of 3-15 °C/h, to give a seed crystal of CsB₄O₆F; and
d) growing the crystal in the melt of the compound by the Czochralski method, comprising
fixing the seed crystal obtained from step c) onto a seed crystal rod; lowering the seed crystal to 1 mm above the liquid surface from the top of a crystal growing furnace for the melt prepared in step b), and preheating it for 5-60 minutes; then immersing the seed crystal in the liquid at 1-5 mm below the surface; rotating the crystal at 2-30 rpm by a crystal growth controller and controlling the temperature to saturate the melt; lifting the seed crystal at a rate of 1-3 mm/day while keeping the temperature constant; upon completion of the crystal growth, pulling the crystal on the seed crystal rod, and decreasing the temperature to 300-440 °C at a rate of 0.2-2 °C/h, and further to 30 °C at a rate of 3-15 °C/h, to obtain the nonlinear optical crystal of CsB₄O₆F;
alternatively, growing the crystal in the melt of the compound by the Kyropoulos method, comprising
fixing the seed crystal obtained from step c) onto a seed crystal rod; lowering the seed crystal to 1 mm above the liquid surface from the top of a crystal growing furnace for the melt prepared in step b), and preheating it for 5-60 minutes; then immersing the seed crystal in the liquid at 1-5 mm below the surface; decreasing the temperature at a rate of 0.1-0.7 °C/h; 3-10 hours later, lifting the seed crystal by 1-2 mm, and further decreasing the temperature at a rate of 0.1-0.7 °C/h; upon completion of the crystal growth, pulling the crystal on the seed crystal rod, and decreasing the temperature to 300-440 °C at a rate of 0.2-2 °C/h, and further to 30 °C at a rate of 3-15 °C/h, to obtain the nonlinear optical crystal of CsB₄O₆F;
alternatively, growing the crystal in the melt of the compound by the Bridgeman-Stockbarger method, comprising
placing the seed crystal prepared in step c) at the bottom of a crucible, then adding the polycrystal compound of CsB₄O₆F prepared in step a) to the crucible; sealing the platinum crucible, and increasing the temperature of the growing furnace to 500-700 °C for 7-15 hours; adjusting the position of the crucible such that the seeding temperature is 500-625 °C; then lowering the crucible at a rate of 1-10 mm/day while keeping the growth temperature constant; upon completion of the growth, decreasing the temperature to 300-440 °C at a rate of 0.2-2 °C/h, and further to 30 °C at a rate of 3-15 °C/h; and removing the platinum crucible, to obtain the nonlinear optical crystal of CsB₄O₆F;
the high temperature solution method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2 to obtain a mixture; filling the mixture into a platinum crucible; then placing the platinum crucible in a muffle furnace, and increasing the temperature to 350-600 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄;
b) mixing the polycrystal powder of the compound of CsB₄O₆F obtained from step a) homogeneously with a fluxing agent at a molar ratio of 1:0.1-0.5; then filling the mixture into a clean platinum crucible, and increasing the temperature to 400-700 °C at a rate of 35-45 °C/h for 7-15 hours, to give a mixed solution; wherein the Cs-containing compound is Cs₂CO₃, CsNO₃, CsHCO₃, CsF or CsBF₄; the F-containing compound is CsF or CsBF₄; the B-containing compound is H₃BO₃, B₂O₃ or CsBF₄; and the fluxing agent is CsF, H₃BO₃, B₂O₃, PbO or PbF₂;
c) preparation of a seed crystal: placing the mixed solution prepared in step b) into a single crystal furnace, and then decreasing the temperature to 350-610 °C at a rate of 0.1-5 °C/h, to 300-385 °C at a rate of 0.2-0.6 °C/h, and further to 30 °C at a rate of 3-10 °C/h, to give a seed crystal of CsB₄O₆F; and
d) growth of a crystal: fixing the resultant seed crystal of CsB₄O₆F onto a seed crystal rod; lowering the seed crystal to 1 mm above the liquid surface from the top of a crystal growing furnace for the mixed solution prepared in step b), and preheating it for 10-25 minutes; contacting the seed crystal with the liquid surface, and decreasing the temperature at a rate of 0.1-2 °C/h; upon completion of the crystal growth, pulling the crystal away from the surface of the solution, and then decreasing the temperature to 30 °C at a rate of 3-10 °C/h, to obtain the nonlinear optical crystal of CsB₄O₆F;
the vacuum encapsulation method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C at a rate of 10-50 °C for 3-96 hours, to give a polycrystal powder of the compound of CsB₄O₆F; wherein the Cs-containing compound is Cs₂CO₃, CsNO₃, CsHCO₃, CsF or CsBF₄; the F-containing compound is CsF or CsBF₄; and the B-containing compound is H₃BO₃, B₂O₃ or CsBF₄; and
b) mixing the polycrystal powder of the compound of CsB₄O₆F obtained from step a) homogeneously with a fluxing agent at a molar ratio of 1:0.1-1; then filling the mixture into a quartz tube, and increasing the temperature to 400-700 °C at a rate of 10-50 °C/h for 3-96 hours; then decreasing the temperature to 330-450 °C at a rate of 0.5-1.5 °C/day, and further to 30 °C at a rate of 2-5 °C/h; and cutting the quartz tube to obtain the nonlinear optical crystal of CsB₄O₆F; wherein the Cs-containing compound is Cs₂CO₃, CsNO₃, CsHCO₃, CsF or CsBF₄; the F-containing compound is CsF, CsBF4 or HF; the B-containing compound is H₃BO₃, B₂O₃ or CsBF₄; and the fluxing agent is CsF, H₃BO₃, B₂O₃, PbO or PbF₂;
the hydrothermal method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder product of CsB₄O₆F; wherein the Cs-containing compound is Cs₂CO₃, CsNO₃, CsHCO₃, CsF or CH₃COOCs; the F-containing compound is CsF or HF; and the B-containing compound is H₃BO₃ or B₂O₃;
b) dissolving the polycrystal powder of the compound of CsB₄O₆F obtained from step a) in 5-30 mL of deionized water, and sonicating the incompletely dissolved mixture at a temperature of 20-50 °C for 5-30 minutes to allow for sufficient mixing and dissolution;
c) transferring the mixed solution obtained from step b) into the lining of a clean, pollution-free high pressure reactor with a volume of 100 mL, and tightening and sealing the reactor; and
d) placing the high pressure reactor in a thermostat, increasing the temperature to 150-350 °C at a rate of 5-50 °C/h for 3-15 days, and then decreasing the temperature to room temperature at a rate of 5-30 °C/day, to obtain the nonlinear optical crystal of CsB₄O₆F;
and
the room temperature solution method for growing the nonlinear optical crystal of cesium fluorooxoborate comprises the following steps:
a) mixing a Cs-containing compound, a B-containing compound and an F-containing compound homogeneously at a molar ratio of Cs:B:F=0.5-2:3-5:0.5-2; filling the mixture into a platinum crucible; then placing the platinum crucible in a muffle furnace, and increasing the temperature to 350-600 °C for 3-96 hours, to give a polycrystal powder product of CsB₄O₆F; wherein the Cs-containing compound is Cs₂CO₃, CsNO₃, CsHCO₃, CsF or CH₃COOCs; the F-containing compound is CsF or HF; and the B-containing compound is H₃BO₃ or B₂O₃;
b) placing the polycrystal powder of the compound of CsB₄O₆F obtained from step a) in a clean glass container, to which 20-100 mL of deionized water is added, followed by ultrasonication for 5-60 minutes to allow for sufficient mixing and dissolution, and then adjusting the pH of the solution to 8-11 by addition of HF or CsOH;
c) sealing the container containing the solution in step b) with weighing paper, and placing it in a static environment without shaking, pollution and air convection; controlling the evaporation rate at 0.2-2 mL/day by piercing the seal; and setting it aside for 5-20 days at room temperature;
d) obtaining a seed crystal upon completion of the growth when the size of the crystal particles grown at the bottom of the container from the solution in step c) is no longer changed significantly; and
e) filtering the remaining solution through qualitative filter paper to filter out grains and other impurities from the solution; selecting the seed crystal of better quality, fixing it with a platinum wire and suspending it in the filtered solution; controlling the evaporation rate at 0.2-2 mL/day by piercing the seal, and setting it aside for growth for 5-20 days at room temperature, to obtain the nonlinear optical crystal of CsB₄O₆F.

5. Use of the nonlinear optical crystal of cesium fluorooxoborate of claim 3 in the manufacture of an Nd:YAG laser that outputs a fundamental frequency light of 1064 nm for the second, third, fourth, fifth or sixth harmonic generation laser output.

6. Use of the nonlinear optical crystal of cesium fluorooxoborate of claim 3 in the production of a deep-ultraviolet frequency-multiplied light below 200 nm.

7. Use of the nonlinear optical crystal of the compound of cesium fluorooxoborate of claim 3 in the manufacture of a frequency multiplication generator, a frequency up or down converter or an optical parametric oscillator.

## Patentansprüche

1. Verbindung von Cäsiumfluoroxoborat, wobei eine chemische Formel der Verbindung CsB₄O₆F ist und ein Molekulargewicht der Verbindung 291,15 beträgt.

2. Verfahren zur Herstellung einer Verbindung von Cäsiumfluoroxoborat nach Anspruch 1, wobei die Verbindung durch ein Festkörpersyntheseverfahren oder ein Vakuumverkapselungsverfahren hergestellt wird;
das Festkörpersyntheseverfahren zur Herstellung der Verbindung von Cäsiumfluoroxoborat die folgenden Schritte umfasst:
Mischen einer Cs-haltigen Verbindung, einer B-haltigen Verbindung und einer F-haltigen Verbindung homogen bei einem Molverhältnis von Cs:B:F=0,5-2:3-5:0,5-2; Füllen der Mischung in einen Platintiegel; dann Anordnen des Platintiegels in einem Muffelofen und Erhöhen der Temperatur auf 350-600 °C für 3-96 Stunden, um die Verbindung von CsB₄O₆F zu ergeben; worin die Cs-haltige Verbindung Cs₂CO₃, CsNO₃, CsHCO₃, CsF oder CsBF₄ ist; die F-haltige Verbindung CsF oder CsBF₄ ist; und die B-haltige Verbindung H₃BO₃, B₂O₃ oder CsBF₄ ist; und
das Vakuumverkapselungsverfahren zur Herstellung der Verbindung von Cäsiumfluoroxoborat,
Mischen einer Cs-haltigen Verbindung, einer B-haltigen Verbindung und einer F-haltigen Verbindung homogen bei einem Molverhältnis von Cs:B:F=0.5-2:3-5:0.5-2; Füllen der Mischung in ein Φ40 mm Quarzrohr; Vakuumisieren des Quarzrohrs auf einen Vakuumgrad von 1 x 10⁻³ Pa, und Abdichten bei einer hohen Temperatur; dann Anordnen des Quarzrohrs in einem Muffelofen und Erhöhen der Temperatur mit einer Geschwindigkeit von 10-50 °C für 3-96 Stunden auf 350-600 °C, um die Verbindung von CsB₄O₆F zu ergeben; worin die Cs-haltige Verbindung Cs₂CO₃, CsNO₃, CsHCO₃ , CsF oder CsBF₄ ist; die F-haltige Verbindung CsF oder CsBF₄ ist; und die B-haltige Verbindung H₃BO₃, B₂O₃ oder CsBF₄ ist.

3. Nichtlinearer optischer Kristall aus Cäsiumfluoroxoborat, wobei eine chemische Formel des Kristalls CsB₄O₆F ist und ein Molekulargewicht des Kristalls 291,15 beträgt und der Kristall zu einem orthorhombischen Kristallsystem mit einer Raumgruppe von *Pna2₁,* Kristallzellparametern von *a* = 7,9241 Å, *b* = 11,3996 Å, *c* = 6,6638Ä, und *α*=*β*=*γ*=90° und einem Einheitszellenvolumen von 601,95 Å³ gehört.

4. Verfahren zur Herstellung des nichtlinearen optischen Kristalls aus Cäsiumfluoroxoborat nach Anspruch 3, wobei der Kristall durch ein Schmelzverfahren, ein Hochtemperaturlösungsverfahren, ein Vakuumverkapselungsverfahren, ein hydrothermales Verfahren oder ein Raumtemperaturlösungsverfahren gezüchtet wird; wobei
das Schmelzverfahren zum Züchten des nichtlinearen optischen Kristalls von Cäsiumfluoroxoborat die folgenden Schritte umfasst:
a) Mischen einer Cs-haltigen Verbindung, einer B-haltigen Verbindung und einer F-haltigen Verbindung homogen bei einem Molverhältnis von Cs:B:F=0,5-2:3-5:0,5-2; Füllen der Mischung in einen Platintiegel; dann Anordnen des Platintiegels in einem Muffelofen und Erhöhen der Temperatur auf 350-600 °C für 3-96 Stunden, um ein polykristallines Pulver der Verbindung von CsB₄O₆F zu ergeben; worin die Cs-haltige Verbindung Cs₂CO₃, CsNO₃, CsHCO₃, CsF oder CsBF₄ ist_{;} die F-haltige Verbindung CsF oder CsBF₄ ist; und die B-haltige Verbindung H₃BO₃, B₂O₃ oder CsBF₄ ist;
b) Füllen des resultierenden Polykristallpulvers der Verbindung von CsB₄O₆F in einen sauberen Platintiegel; Anordnen des Platintiegels in einem Muffelofen und Erhöhen der Temperatur auf 400-700 °C mit einer Geschwindigkeit von 20-40 °C/h für 7-15 Stunden, um eine Schmelze zu ergeben; worin die Cs-haltige Verbindung Cs₂CO₃, CsNC₃, CsHCO₃, CsF oder CsBF₄ ist; die F-haltige Verbindung CsF oder CsBF₄ ist; und die B-haltige Verbindung H₃BO₃, B₂O₃ oder CsBF₄ ist;
c) Verringern der Temperatur der Schmelze von Schritt b) auf 400-590 °C mit einer Geschwindigkeit von 0,1-5 °C/h, auf 300-440 °C mit einer Geschwindigkeit von 0,2-2 °C/h, und ferner auf 30 °C mit einer Geschwindigkeit von 3-15 °C/h, um einen Impfkristall von CsB₄O₆F zu ergeben; und
d) Züchten des Kristalls in der Schmelze der Verbindung nach der Czochralski-Methode, umfassend
Fixieren des aus Schritt c) erhaltenen Impfkristalls auf einem Impfkristallstab;
Absenken des Impfkristalls auf 1 mm über der Flüssigkeitsoberfläche von der Oberseite eines Kristallwachstumsofens für die in Schritt b) hergestellte Schmelze und Vorheizen für 5-60 Minuten; dann Eintauchen des Impfkristalls in die Flüssigkeit 1-5 mm unter der Oberfläche; Drehen des Kristalls mit 2 bis 30 U/min durch einen Kristallwachstumsregler und Steuern der Temperatur, um die Schmelze zu sättigen;
Anheben des Impfkristalls mit einer Geschwindigkeit von 1 bis 3 mm/Tag bei konstanter Temperatur; nach Beendigung des Kristallwachstums wird der Kristall am Impfkristallstab gezogen und die Temperatur mit einer Geschwindigkeit von 0,2 bis 2 °C/h auf 300 bis 440 °C und mit einer Geschwindigkeit von 3 bis 15 °C/h weiter auf 30 °C verringert, um den nichtlinearen optischen Kristall von CsB₄O₆F zu erhalten;
alternativ Züchten des Kristalls in der Schmelze der Verbindung nach dem Kyropoulos-Verfahren, umfassend
Fixieren des aus Schritt c) erhaltenen Impfkristalls auf einem Impfkristallstab;
Absenken des Impfkristalls auf 1 mm über der Flüssigkeitsoberfläche von der Oberseite eines Kristallwachstumsofens für die in Schritt b) hergestellte Schmelze, und Vorheizen für 5-60 Minuten; dann Eintauchen des Impfkristalls in die Flüssigkeit 1-5 mm unter der Oberfläche; Verringern der Temperatur mit einer Geschwindigkeit von 0,1 bis 0,7 °C/h; 3-10 Stunden später, Anheben des Impfkristalls um 1-2 mm und weiteres Verringern der Temperatur mit einer Geschwindigkeit von 0,1-0,7 °C/h; nach Beendigung des Kristallwachstums wird der Kristall am Impfkristallstab gezogen und die Temperatur mit einer Geschwindigkeit von 0,2 bis 2 °C/h auf 300 bis 440 °C und mit einer Geschwindigkeit von 3 bis 15 °C/h weiter auf 30 °C veringert, um den nichtlinearen optischen Kristall von CsB₄O₆F zu erhalten;
alternativ Züchten des Kristalls in der Schmelze der Verbindung nach dem Bridgeman-Stockbarger-Verfahren, umfassend
Anordnen des in Schritt c) hergestellten Impfkristalls am Boden eines Tiegels und anschließendes Hinzufügen der in Schritt a) hergestellten Polykristallverbindung von CsB₄O₆F zu dem Tiegel; Versiegeln des Platintiegels und Erhöhen der Temperatur des Wachstumsofens auf 500-700 °C für 7-15 Stunden; Einstellen der Position des Tiegels so, dass die Aussaattemperatur 500-625 °C beträgt; dann Absenken des Tiegels mit einer Geschwindigkeit von 1-10 mm/Tag, während die Wachstumstemperatur konstant gehalten wird; nach Beendigung des Wachstums wird die Temperatur mit einer Geschwindigkeit von 0,2 bis 2 °C/h auf 300 bis 440 °C und mit einer Geschwindigkeit von 3 bis 15 °C/h weiter auf 30 °C verringert, um den nichtlinearen optischen Kristall von CsB₄O₆F zu erhalten;
das Hochtemperaturlösungsverfahren zum Züchten des nichtlinearen optischen Kristalls von Cäsiumfluoroxoborat umfasst die folgenden Schritte:
a) Mischen einer Cs-haltigen Verbindung, einer B-haltigen Verbindung und einer F-haltigen Verbindung homogen bei einem Molverhältnis von Cs:B:F=0,5-2:3-5:0,5-2, um eine Mischung zu erhalten; Füllen der Mischung in einen Platintiegel; dann Anordnen des Platintiegels in einem Muffelofen und Erhöhen der Temperatur für 3-96 Stunden auf 350-600 °C, um ein polykristallines Pulver der Verbindung von CsB₄O₆F zu ergeben; worin die Cs-haltige Verbindung Cs₂CO₃, CsNO₃, CsHCO₃, CsF oder CsBF₄ ist; die F-haltige Verbindung CsF oder CsBF₄ ist; und die B-haltige Verbindung H₃BO₃, B₂O₃ oder CsBF₄ ist;
b) Mischen des Polykristallpulvers der in Schritt a) erhaltenen Verbindung von CsB₄O₆F homogen mit einem Flussmittel in einem Molverhältnis von 1:0,1-0,5; dann Füllen der Mischung in einen sauberen Platintiegel und Erhöhen der Temperatur auf 400-700 °C mit einer Geschwindigkeit von 35-45 °C/h für 7-15 Stunden, um eine gemischte Lösung zu ergeben; worin die Cs-haltige Verbindung Cs₂CO₃, CsNO₃, CsHCO₃, CsF oder CsBF₄ ist; die F-haltige Verbindung CsF oder CsBF₄ ist; die B-haltige Verbindung H₃BO₃, B₂O₃ oder CsBF₄ ist; und das Flussmittel CsF, H₃BO₃, B₂O₃, PbO oder PbF₂ ist;
c) Herstellung eines Impfkristalls: Anordnen der in Schritt b) hergestellten gemischten Lösung in einem Einkristallofen und anschließendes Verringern der Temperatur auf 350-610 °C mit einer Geschwindigkeit von 0,1-5 °C/h, auf 300-385 °C mit einer Geschwindigkeit von 0,2-0,6 °C/h, und weiter auf 30 °C mit einer Geschwindigkeit von 3-10 ° C/h, um einen Impfkristall von CsB₄O₆F zu ergeben; und
d) Wachstum eines Kristalls: Fixieren des resultierenden Impfkristalls von CsB₄O₆F auf einem Impfkristallstab; Absenken des Impfkristalls auf 1 mm über der Flüssigkeitsoberfläche von der Oberseite eines Kristallwachstumsofens für die in Schritt b) hergestellte gemischte Lösung und Vorheizen für 10 bis 25 Minuten;
Inkontaktbringen des Impfkristalls mit der Flüssigkeitsoberfläche und Verringern der Temperatur mit einer Geschwindigkeit von 0,1-2 °C/h; nach Beendigung des Kristallwachstums wird der Kristall von der Oberfläche der Lösung weggezogen und dann die Temperatur mit einer Geschwindigkeit von 3 bis 10 °C/h auf 30 °C verringert, um den nichtlinearen optischen Kristall von CsB₄O₆F zu erhalten; das Vakuumverkapselungsverfahren zum Züchten des nichtlinearen optischen
Kristalls von Cäsiumfluoroxoborat umfasst die folgenden Schritte:
a) Mischen einer Cs-haltigen Verbindung, einer B-haltigen Verbindung und einer F-haltigen Verbindung homogen bei einem Molverhältnis von Cs:B:F=0,5-2:3-5:0,5-2; Füllen der Mischung in einen Platintiegel; dann Anordnen des Platintiegels in einem Muffelofen, und Erhöhen der Temperatur auf 350-600 °C mit einer Geschwindigkeit von 10-50 °C für 3-96 Stunden, um ein Polykristallpulver der Verbindung von CsB₄O₆F zu ergeben; worin die Cs-haltige Verbindung Cs₂CO₃, CsNO₃, CsHCO₃, CsF oder CsBF₄ ist; die F-haltige Verbindung CsF oder CsBF₄ ist; und die B-haltige Verbindung H₃BO₃, B₂O₃ oder CsBF₄ ist; und
b) Mischen des Polykristallpulvers der in Schritt a) erhaltenen Verbindung von CsB₄O₆F homogen mit einem Flussmittel in einem Molverhältnis von 1:0,1-1;
Füllen der Mischung in ein Quarzrohr und Erhöhen der Temperatur 3-96 Stunden lang mit einer Geschwindigkeit von 10-50 °C/h auf 400-700 °C; dann Verringern der Temperatur auf 330-450 °C mit einer Geschwindigkeit von 0,5-1,5 °C/Tag, und weiter auf 30 °C mit einer Geschwindigkeit von 2-5 °C/h; und Schneiden der Quarzröhre, um den nichtlinearen optischen Kristall von CsB₄O₆F zu erhalten; worin die Cs-haltige Verbindung Cs₂CO₃, CsNO₃, CsHCO₃, CsF oder CsBF₄ ist; die F-haltige Verbindung CsF, CsBF₄ oder HF ist; die B-haltige Verbindung H₃BO₃, B₂O₃ oder CsBF₄ ist; und das Flussmittel CsF, H₃BO₃, B₂O₃, PbO oder PbF₂ ist;
das hydrothermale Verfahren zum Züchten des nichtlinearen optischen Kristalls von Cäsiumfluoroxoborat umfasst die folgenden Schritte:
a) Mischen einer Cs-haltigen Verbindung, einer B-haltigen Verbindung und einer F-haltigen Verbindung homogen bei einem Molverhältnis von Cs:B:F=0.5-2:3-5:0.5-2; Füllen der Mischung in einen Platintiegel; dann Anordnen des Platintiegels in einem Muffelofen und Erhöhen der Temperatur auf 350-600 °C für 3-96 Stunden, um ein Polykristallpulverprodukt von CsB₄O₆F zu ergeben;
worin die Cs-haltige Verbindung Cs₂CO₃, CsNO₃, CsHCO₃, CsF oder CH₃COOCs ist; die F-haltige Verbindung CsF oder HF ist; und die B-haltige Verbindung ist H₃BO₃ oder B₂O₃ ist;
b) Lösen des Polykristallpulvers der aus Schritt a) erhaltenen Verbindung von CsB₄O₆F in 5 bis 30 ml entionisiertem Wasser und Ultraschallbehandlung der unvollständig gelösten Mischung bei einer Temperatur von 20 bis 50 °C für 5 bis 30 Minuten, um ein ausreichendes Mischen und Auflösen zu ermöglichen;
c) Überführen der aus Schritt b) erhaltenen gemischten Lösung in die Auskleidung eines sauberen, umweltfreundlichen Hochdruckreaktors mit einem Volumen von 100 ml und Abdichten und Verschließen des Reaktors; und
d) Anordnen des Hochdruckreaktors in einem Thermostat, Erhöhen der Temperatur auf 150-350 °C mit einer Geschwindigkeit von 5-50 ° C/h für 3-15 Tage und anschließendes Verringern der Temperatur auf Raumtemperatur mit einer Geschwindigkeit von 5-30 °C/Tag, um den nichtlinearen optischen Kristall von CsB₄O₆F zu erhalten; und
das Lösungsverfahren bei Raumtemperatur zum Züchten des nichtlinearen optischen Kristalls von Cäsiumfluoroxoborat umfasst die folgenden Schritte:
a) Mischen einer Cs-haltigen Verbindung, einer B-haltigen Verbindung und einer F-haltigen Verbindung homogen bei einem Molverhältnis von Cs:B:F=0.5-2:3-5:0.5-2; Füllen der Mischung in einen Platintiegel; dann Anordnen des Platintiegels in einem Muffelofen und Erhöhen der Temperatur auf 350-600 °C für 3-96 Stunden, um ein Polykristallpulverprodukt von CsB₄O₆F zu ergeben;
worin die Cs-haltige Verbindung Cs₂CO₃, CsNO₃, CsHCO₃, CsF oder CH₃COOCs ist; die F-haltige Verbindung CsF oder HF ist; und die B-haltige Verbindung ist H₃BO₃ oder B₂O₃ ist;
b) Anordnen des aus Schritt a) erhaltenen Polykristallpulvers der Verbindung von CsB₄O₆F in einem sauberen Glasbehälter, zu dem 20 bis 100 ml entionisiertes Wasser gegeben werden, gefolgt von 5 bis 60 Minuten Ultraschallbeschallung, um ein ausreichendes Mischen und Auflösen zu ermöglichen, und anschließendes Einstellen des pH-Werts der Lösung auf 8 bis 11 durch Zugabe von HF oder CsOH;
c) Verschließen des Behälters mit der Lösung in Schritt b) mit Wiegepapier und Anordnen dessen in einer statischen Umgebung ohne Schütteln, Verschmutzung und Luftkonvektion; Steuern der Verdampfungsrate auf 0,2-2 ml/Tag durch Durchstechen der Versiegelung; und beiseite stellen für 5-20 Tage bei Raumtemperatur;
d) Erhalten eines Impfkristalls nach Beendigung des Wachstums, wenn sich die Größe der Kristallpartikel, die am Boden des Behälters aus der Lösung in Schritt c) gewachsen sind, nicht mehr signifikant geändert hat; und
e) Filtrieren der verbleibenden Lösung durch qualitatives Filterpapier, um Körner und andere Verunreinigungen aus der Lösung herauszufiltern; Auswahl des Impfkristalls von besserer Qualität, Fixieren mit einem Platindraht und Suspendieren in der filtrierten Lösung; Steuern der Verdampfungsrate auf 0,2-2 ml/Tag durch Durchstechen der Versiegelung und beiseite stellen für das Wachstum für 5-20 Tage bei Raumtemperatur, um den nichtlinearen optischen Kristall von CsB₄O₆F zu erhalten.

5. Verwendung des nichtlinearen optischen Kristalls aus Cäsiumfluoroxoborat nach Anspruch 3 bei der Herstellung eines Nd:YAG-Lasers, der ein Grundfrequenzlicht von 1064 nm zur Erzeugung der zweiten, dritten, vierten, fünften oder sechsten Harmonischen der Laserleistung ausgibt.

6. Verwendung des nichtlinearen optischen Kristalls von Cäsiumfluoroxoborat nach Anspruch 3 bei der Erzeugung eines mit tiefer Ultraviolettfrequenz multiplizierten Lichts unter 200 nm.

7. Verwendung des nichtlinearen optischen Kristalls der Verbindung von Cäsiumfluoroxoborat nach Anspruch 3 bei der Herstellung eines Frequenzvervielfachungsgenerators, eines Frequenzaufwärts- oder -abwärtswandlers oder eines optisch parametrischen Oszillators.

## Revendications

1. Composé de fluorooxoborate de césium, où une formule chimique du composé est CsB₄O₆F, et une masse moléculaire du composé est 291,15.

2. Procédé de préparation d'un composé de fluorooxoborate de césium selon la revendication 1, où le composé est préparé selon un procédé de synthèse à l'état solide ou un procédé d'encapsulation sous vide ;
ledit procédé de synthèse à l'état solide destiné à la préparation du composé de fluorooxoborate de césium comprend les étapes suivantes :
le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un creuset en platine ; puis le placement du creuset en platine dans un four à moufle, et l'augmentation de la température jusqu'à la plage comprise entre 350 et 600 °C pendant 3 à 96 heures, pour donner le composé de CsB₄O₆F ; où le composé contenant du Cs est Cs₂CO₃, CsNO₃, CsHCO₃, CsF ou CsBF₄ ; le composé contenant du F est CsF ou CsBF₄ ; et le composé contenant du B est H₃BO₃, B₂O₃ ou CsBF₄ ; et
ledit procédé d'encapsulation sous vide destiné à la préparation du composé de fluorooxoborate de césium,
le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un tube de quartz de Φ40 mm ; la mise sous vide du tube de quartz à un degré de vide de 1 x 10⁻³ Pa, et le scellement à une haute température ; puis le placement du tube de quartz dans un four à moufle, et l'augmentation de la température jusqu'à la plage comprise entre 350 et 600 °C à une vitesse comprise entre 10 et 50 °C pendant 3 à 96 heures, pour donner le composé de CsB₄O₆F ; où le composé contenant du Cs est Cs₂CO₃, CsNO₃, CsHCO₃, CsF ou CsBF₄ ; le composé contenant du F est CsF ou CsBF₄ ; et le composé contenant du B est H₃BO₃, B₂O₃ ou CsBF₄.

3. Cristal optique non linéaire de fluorooxoborate de césium, où une formule chimique du cristal est CsB₄O₆F et une masse moléculaire du cristal est 291,15, et le cristal appartient à un système cristallin orthorhombique, ayant un groupe spatial de *Pna2₁,* présentant des paramètres de cellule cristalline de *a* = 7,9241 Å, *b* = 11,3996 Å,
*c* = 6,6638Å, et *α* = *β* = *γ* = 90 °, et un volume de cellule unitaire de 601,95 Å³.

4. Procédé de préparation du cristal optique non linéaire de fluorooxoborate de césium selon la revendication 3, où le cristal est accru selon un procédé de fusion, un procédé de mise en solution à haute température, un procédé d'encapsulation sous vide, un procédé hydrothermal ou un procédé de mise en solution à température ambiante ;
le procédé de fusion destiné à la croissance du cristal optique non linéaire de fluorooxoborate de césium comprenant les étapes suivantes :
a) le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un creuset en platine ; puis le placement du creuset en platine dans un four à moufle, et l'augmentation de la température jusqu'à la plage comprise entre 350 et 600 °C pendant 3 à 96 heures, pour donner une poudre polycristalline du composé de CsB₄O₆F ; où le composé contenant du Cs est Cs₂CO₃, CsNO₃, CsHCO₃, CsF ou CsBF₄ ; le composé contenant du F est CsF ou CsBF₄ ; et le composé contenant du B est H₃BO₃, B₂O₃ ou CsBF₄ ;
b) le versement de la poudre polycristalline résultante du composé de CsB₄O₆F dans un creuset en platine propre ; le placement du creuset en platine dans un four à moufle, et l'augmentation de la température jusqu'à la plage comprise entre 400 et 700 °C à une vitesse comprise entre 20 et 40 °C/h pendant 7 à 15 heures, pour donner une matière fondue ; où le composé contenant du Cs est Cs₂CO₃, CsNC₃, CsHCO₃, CsF ou CsBF₄ ; le composé contenant du F est CsF ou CsBF₄ ; et le composé contenant du B est H₃BO₃, B₂O₃ ou CsBF₄ ;
c) la diminution de la température de la matière fondue de l'étape b) jusqu'à la plage comprise entre 400 et 590 °C à une vitesse de 0,1 à 5 °C/h, jusqu'à la plage comprise entre 300 et 440 °C à une vitesse comprise entre 0,2 à 2 °C/h, et en outre jusqu'à 30 °C à une vitesse comprise entre 3 et 15 °C/h, pour donner un germe cristallin de CsB₄O₆F ; et
d) la croissancer du cristal dans la matière fondue du composé selon le procédé de Czochralski, comprenant
la fixation du germe cristallin obtenu à l'étape c) sur une tige de germe cristallin ; l'abaissement du germe cristallin à 1 mm au-dessus de la surface de liquide depuis le haut d'un four de croissance de cristaux pour la matière fondue préparée à l'étape b) et le préchauffement pendant 5 à 60 minutes ; puis l'immersion du germe cristallin dans le liquide à 1 à 5 mm sous la surface ; la rotation du cristal à 2 à 30 tr/min par un vérificatur de croissance de cristaux et la vérification de la température pour saturer la matière fondue ; le soulèvement du germe cristallin à une vitesse de 1 à 3 mm/jour tout en maintenant la température constante ; à la fin de la croissance de cristaux, le tirage du cristal sur la tige de germe cristallin, et la diminution de la température jusqu'à la plage comprise entre 300 et 440 °C à une vitesse comprise entre 0,2 et 2 °C/h, et en outre jusqu'à 30 °C à une vitesse comprise entre 3 et 15 °C/h, pour obtenir le cristal optique non linéaire de CsB₄O₆F ;
la croissance, alternativement, du cristal dans la matière fondue du composé selon le procédé de Kyropoulos, comprenant
la fixation du germe cristallin obtenu à l'étape c) sur une tige de germe cristallin ;
l'abaissement du germe cristallin à 1 mm au-dessus de la surface de liquide depuis le haut d'un four de croissance de cristaux pour la matière fondue préparée à l'étape b) et le préchauffement pendant 5 à 60 minutes ; puis l'immersion du germe cristallin dans le liquide à 1 à 5 mm sous la surface ; la diminution de la température à une vitesse comprise entre 0,1 et 0,7 °C/h ; 3 à 10 heures plus tard, le soulèvement du germe cristallin de 1 à 2 mm et la diminution en outre de la température à une vitesse comprise entre 0,1 et 0,7 °C/h ; à la fin de la croissance de cristaux, le tirage du cristal sur la tige de germe cristallin, et la diminution de la température jusqu'à la plage comprise entre 300 et 440 °C à une vitesse comprise entre 0,2 et 2 °C/h, puis jusqu'à 30 °C à une vitesse comprise entre 3 et 15 °C/h, pour obtenir le cristal optique non linéaire de CsB₄O₆F ;
la croissance, alternativement, du cristal dans la matière fondue du composé selon le procédé de Bridgeman-Stockbarger, comprenant
le placement du germe cristallin préparé à l'étape c) au fond d'un creuset, puis l'ajout du composé polycristallin de CsB₄O₆F préparé à l'étape a) au creuset ; le scellement du creuset en platine, et l'augmentation de la température du four de croissance jusqu'à la plage comprise entre 500 et 700 °C pendant 7 à 15 heures ; l'ajustement de la position du creuset de telle sorte que la température d'ensemencement est dans la plage comprise entre 500 et 625 °C ; puis l'abaissement du creuset à une vitesse comprise entre 1 et 10 mm/jour tout en maintenant la température de croissance constante ; à la fin de la croissance, la diminution de la température jusqu'à la plage comprise entre 300 et 440 °C à une vitesse comprise entre 0,2 et 2 °C/h, et en outre jusqu'à 30 °C à une vitesse comprise entre 3 et 15 °C/h ; et le retraitr du creuset en platine, pour obtenir le cristal optique non linéaire de CsB₄O₆F ;
le procédé de mise en solution à haute température destiné à la croissance du cristal optique non linéaire de fluorooxoborate de césium comprend les étapes suivantes :
a) le mélange d'un composé contenant du Cs, d'un composé contenant du B et d'un composé contenant du F de manière homogène à un rapport molaire de Cs:B:F = 0,5-2:3-5:0,5-2 pour obtenir un mélange ; le versement du mélange dans un creuset en platine ; puis le placement du creuset en platine dans un four à moufle, et l'augmentation de la température jusqu'à la plage comprise entre 350 et 600 °C pendant 3 à 96 heures, pour donner une poudre polycristalline du composé de CsB₄O₆F ; où le composé contenant du Cs est Cs₂CO₃, CsNO₃, CsHCO₃, CsF ou CsBF₄ ; le composé contenant du F est CsF ou CsBF₄ ; et le composé contenant du B est H₃BO₃, B₂O₃ ou CsBF₄ ;
b) le mélange de la poudre polycristalline du composé de CsB₄O₆F obtenue à l'étape a) de manière homogène avec un agent fluxant à un rapport molaire de 1:0,1-0,5 ; puis le versement du mélange dans un creuset en platine propre, et l'augmentation de la température jusqu'à la plage comprise entre 400 et 700 °C à une vitesse comprise entre 35 et 45 °C/h pendant 7 à 15 heures, pour donner une solution mélangée ; où le composé contenant du Cs est Cs₂CO₃, CsNO₃, CsHCO₃, CsF ou CsBF₄ ; le composé contenant du F est CsF ou CsBF₄ ; le composé contenant du B est H₃BO₃, B₂O₃ ou CsBF₄ ; et l'agent fluxant étant CsF, H₃BO₃, B₂O₃, PbO ou PbF₂ ;
c) la préparation d'un germe cristallin : le placement de la solution mélangée préparée à l'étape b) dans un four à monocristaux, puis la diminution de la température jusqu'à la plage comprise entre 350 et 610 °C à une vitesse comprise entre 0,1 et 5 °C/h, jusqu'à entre 300 et 385 °C à une vitesse comprise entre 0,2 et 0,6 °C/h, et en outre jusqu'à 30 °C à une vitesse comprise entre 3 et 10 °C/h, pour donner un germe cristallin de CsB₄O₆F ; et
d) la croissance d'un cristal : la fixation du germe cristallin résultant de CsB₄O₆F sur une tige de germe cristallin ; l'abaissement du germe cristallin à 1 mm au-dessus de la surface de liquide depuis le haut d'un four de croissance de cristaux pour la solution mélangée préparée à l'étape b), et son préchauffement pendant 10 à 25 minutes ; la mise en contact le germe cristallin avec la surface de liquide et la diminution de la température à une vitesse comprise entre 0,1 et 2 °C/h ; à la fin de la croissance de cristaux, l'éloignement du cristal de la surface de la solution, puis la diminution de la température jusqu'à 30 °C à une vitesse comprise entre 3 et 10 °C/h, pour obtenir le cristal optique non linéaire de CsB₄O₆F ;
le procédé d'encapsulation sous vide destiné à la croissance du cristal optique non linéaire de fluorooxoborate de césium comprend les étapes suivantes :
a) le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un creuset en platine ; puis le placement du creuset en platine dans un four à moufle, et l'augmentation de la température jusqu'à la plage comprise entre 350 et 600 °C à une vitesse comprise entre 10 et 50 °C pendant 3 à 96 heures, pour donner une poudre polycristalline du composé de CsB₄O₆F ; où le composé contenant du Cs est Cs₂CO₃, CsNO₃, CsHCO₃, CsF ou CsBF₄ ; le composé contenant du F est CsF ou CsBF₄ ; et le composé contenant du B est H₃BO₃, B₂O₃ ou CsBF₄ ; et
b) le mélange de la poudre polycristalline du composé de CsB₄O₆F obtenue à l'étape a) de manière homogène avec un agent fluxant à un rapport molaire de 1:0,1-1 ; puis le versement du mélange dans un tube de quartz, et l'augmentation de la température jusqu'à la plage comprise entre 400 et 700 °C à une vitesse comprise entre 10 et 50 °C/h pendant 3 à 96 heures ; puis la diminuation de la température jusqu'à la plage comprise entre 330 et 450 °C à une vitesse comprise entre 0,5 et 1,5 °C/jour, et en outre jusqu'à 30 °C à une vitesse comprise entre 2 et 5 °C/h ; et la coupe du tube de quartz pour obtenir le cristal optique non linéaire de CsB₄O₆F ; où le composé contenant du Cs est Cs₂CO₃, CsNO₃, CsHCO₃, CsF ou CsBF₄ ; le composé contenant du F est CsF, CsBF₄ ou HF ; le composé contenant du B est H₃BO₃, B₂O₃ ou CsBF₄ ; et l'agent fluxant est CsF, H₃BO₃, B₂O₃, PbO or PbF₂ ;
le procédé hydrothermal destiné à la croissance du cristal optique non linéaire de fluorooxoborate de césium comprend les étapes suivantes :
a) le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un creuset en platine ; puis le placement du creuset en platine dans un four à moufle, et l'augmentation de la température jusqu'à la plage comprise entre 350 et 600 °C pendant 3 à 96 heures, pour donner un produit de poudre polycristalline de CsB₄O₆F ; où le composé contenant du Cs est Cs₂CO₃, CsNO₃, CsHCO₃, CsF ou CH₃COOCs ; le composé contenant du F est CsF ou HF ; et le composé contenant du B est H₃BO₃ or B₂O₃ ;
b) la dissolution de la poudre polycristalline du composé de CsB₄O₆F obtenue à l'étape a) dans 5 à 30 ml d'eau désionisée, et la sonication du mélange incomplètement dissous à une température de 20 à 50 °C pendant 5 à 30 minutes pour permettre un mélange et une dissolution suffisants ;
c) le transfert de la solution mélangée obtenue à l'étape b) dans le revêtement d'un réacteur haute pression propre et sans pollution présentant un volume de 100 mL, et le serrage et le scellement du réacteur ; et
d) le placement du réacteur haute pression dans un thermostat, l'augmentation de la température jusqu'à la plage comprise entre 150 et 350 °C à une vitesse de 5 à 50 °C/h pendant 3 à 15 jours, puis la diminution de la température à la température ambiante à une vitesse comprise entre 5 et 30 °C/jour, pour obtenir le cristal optique non linéaire de CsB₄O₆F ; et
le procédé de mise en solution à température ambiante destiné à la croissance du cristal optique non linéaire de fluorooxoborate de césium comprend les étapes suivantes :
a) le mélange d'un composé contenant du Cs, d'un composé contenant du B et d'un composé contenant du F de manière homogène à un rapport molaire de Cs:B:F = 0,5-2:3-5:0,5-2 ; le versement du mélange dans un creuset en platine ; puis le placement du creuset en platine dans un four à moufle, et l'augmentation de la température jusqu'à la plage comprise entre 350 et 600 °C pendant 3 à 96 heures, pour donner un produit de poudre polycristalline de CsB₄O₆F ; où le composé contenant du Cs est Cs₂CO₃, CsNO₃, CsHCO₃, CsF ou CH₃COOCs ; le composé contenant du F est CsF ou HF ; et le composé contenant du B est H₃BO₃ or B₂O₃ ;
b) le placement de la poudre polycristalline du composé de CsB₄O₆F obtenue à l'étape a) dans un récipient en verre propre, auquel 20 à 100 ml d'eau désionisée sont ajoutés, suivi de l'ultrasonication pendant 5 à 60 minutes pour permettre un mélange et une dissolution suffisants, puis l'ajustement du pH de la solution jusqu'à entre 8 et 11 par addition de HF ou de CsOH ;
c) le scellement du récipient contenant la solution à l'étape b) avec du papier de pesée, et le placement dans un environnement statique sans agitation, pollution et convection d'air ; la vérification du taux d'évaporation compris entre 0,2 et 2 ml/jour par perçage du joint ; et sa mise de côté pendant 5 à 20 jours à la température ambiante ;
d) l'obtention d'un germe cristallin à la fin de la croissance lorsque la taille des particules cristallines accrues au fond du récipient provenant de la solution à l'étape c) n'est plus modifiée de manière significative ; et
e) le filtrage de la solution restante à travers un papier filtre qualitatif pour filtrer les grains et autres impuretés provenant de la solution ; la sélection du germe cristallin de meilleure qualité, sa fixation à l'aide d'un fil de platine et sa suspention dans la solution filtrée ; la vérification du taux d'évaporation compris entre 0,2 et 2 ml/jour par perçage du joint, et sa mise de côté pour accroître pendant 5 à 20 jours à la température ambiante, pour obtenir le cristal optique non linéaire de CsB₄O₆F.

5. Utilisation du cristal optique non linéaire de fluorooxoborate de césium selon la revendication 3 dans la fabrication d'un laser Nd:YAG, lequel émet une lumière de fréquence fondamentale de 1 064 nm destiné à l'émission laser de deuxième, troisième, quatrième, cinquième ou sixième génération d'harmoniques.

6. Utilisation du cristal optique non linéaire de fluorooxoborate de césium selon la revendication 3 dans la production d'une lumière d'ultraviolet profond multipliée en fréquence inférieure à 200 nm.

7. Utilisation du cristal optique non linéaire du composé de fluorooxoborate de césium selon la revendication 3 dans la fabrication d'un générateur de multiplication de fréquence, d'un convertisseur de fréquence ascendant ou descendant ou d'un oscillateur paramétrique optique.
